# EUROPEAN PATENT SPECIFICATION

(11) **EP 3 261 137 B1**
(45) Date of publication and mention of the grant of the patent: **08.05.2019**
(21) Application number: 15882635.4
(22) Date of filing: 20.02.2015
(51) Int. Cl.: H01L 35/30, H01L 35/32

(54) **THERMOELECTRIC CONVERSION MODULE, SENSOR MODULE, AND INFORMATION PROCESSING SYSTEM**
THERMOELEKTRISCHES UMWANDLUNGSMODUL, SENSORMODUL UND INFORMATIONSVERARBEITUNGSSYSTEM
MODULE DE CONVERSION THERMOÉLECTRIQUE, MODULE DE CAPTEUR, ET SYSTÈME DE TRAITEMENT D'INFORMATIONS

(43) Date of publication of application: 27.12.2017
(73) Proprietor: Fujitsu Limited, Kawasaki-shi, Kanagawa 211-8588 (JP)
(72) Inventor: NAKAGAWA, Kanae, Kawasaki-shi Kanagawa 211-8588 (JP); SUZUKI, Takashi, Kawasaki-shi Kanagawa 211-8588 (JP)
(74) Representative: Haseltine Lake LLP
(86) International application number: PCT/JP2015/054799
(87) International publication number: WO 2016/132533

(56) References cited:
- EP-A1- 2 800 157
- EP-A2- 2 475 019
- JP-A- 2006 303 037
- JP-A- 2013 175 620
- JP-A- 2013 175 620
- US-A1- 2002 162 339

## Description

### TECHNICAL FIELD

The present invention relates to a thermoelectric conversion module, a sensor module, and an information processing system.

### BACKGROUND ART

It is promising to use energy harvesting in which power lines and signal lines which are problems, for example, when sensor networks are constructed are unnecessary. As the energy harvesting, in addition to solar power generation, power generation using a thermoelectric conversion device capable of generating power if there is a temperature difference is promising.

For example, a technique of causing a temperature difference to occur through a thermoelectric conversion device using a temporal change in a temperature of a heat source is known. In this case, the heat source is brought into contact with one side of the thermoelectric conversion device, and a heat storage material is brought into contact with the other side. Then, as the temperature of the heat source changes over time, a temperature difference occurs between the heat source and the heat storage material, and the thermoelectric conversion device generates electric power in accordance with the temperature difference.

However, since the heat storage material has a very low thermal conductivity, in a case where the heat storage material is merely brought into contact with the thermoelectric conversion device, a portion of the heat storage material adjacent to the thermoelectric conversion device is repeatedly melted and solidified. For this reason, heat is not transferred to a portion of the heat storage material which is at a distance away from the thermoelectric conversion device, and thus it is difficult to derive the performance of the entire heat storage material.

In this regard, a technique of improving efficiency of heat transfer to a heat storage material by inserting a fin which comes into contact with a thermoelectric conversion device into the heat storage material is known. EP2475019 describes an energy harvesting device comprising a thermoelectric device, a housing enclosing a phase change material and a radio transmitter electrically coupled to the thermoelectric device. The housing includes further a conductive fin therein to provide more uniform distribution of heat to the phase change material.

### CITATION LIST

### PATENT LITERTURE

PTL 1: Japanese Laid-Open Patent Publication No. 2005-269738
PTL 2: Japanese Laid-Open Patent Publication No. 2013-175620

### SUMMARY OF INVENTION

### TECHNICAL PROBLEM

However, in a case where heat is transferred to the heat storage material using the fin, since it is difficult for the heat to be transferred up to a leading end side of the fin, the heat storage material around a side close to the thermoelectric conversion device of the fin (a side close to the heat source) starts to be melted faster than that around a side far from the thermoelectric conversion device of the fin (a leading end side) . Further, the temperature starts to increases due to sensible heat around the side close to the thermoelectric conversion device of the fin before the melting of the heat storage material extends to the entire heat storage material.

In other words, the temperature of the heat storage material is maintained at the melting point using the latent heat until the entire heat storage material is completely melted, and large electric power is obtained by the thermoelectric conversion device using the temperature difference between the melting point and the heat source. However, since the temperature starts to increase around the side close to the thermoelectric conversion device of the fin, and the temperature difference which is able to be caused by the thermoelectric conversion device decreases, a power generation amount smaller than an expected power generation amount is obtained.

In this regard, it is desirable to increase a power generation amount by causing heat to be transferred up to the heat storage material on the side far from the thermoelectric conversion device of the fin and increasing the temperature difference which is able to be caused by the thermoelectric conversion device.

### SOLUTION TO PROBLEM

The present thermoelectric conversion module, includes: a thermoelectric conversion device; a first container; a fin that is thermally connected to one side of the thermoelectric conversion device, has a higher thermal conductivity than the first container, and extends in a direction away from the thermoelectric conversion device in the first container; a first heat dissipation member that is thermally connected to the one side of the thermoelectric conversion device, has a higher thermal conductivity than the fin, and extends up to a side far from the thermoelectric conversion device of the fin in the first container; and a first heat storage material that is disposed in the first container and thermally connected to the fin and the first heat dissipation member.

The present sensor module includes a sensor and the thermoelectric conversion module which is electrically connected to the sensor.

The present information processing system includes the sensor module and a computer that processes data obtained by the sensor module.

### ADVANTAGEOUS EFFECTS OF INVENTION

Accordingly, according to the thermoelectric conversion module, the sensor module, and the information processing system, there is an advantage in that it is possible to increase a power generation amount by causing heat to be transferred up to the heat storage material on the side far from the thermoelectric conversion device of the fin and increasing the temperature difference which is able to be caused by the thermoelectric conversion device.

### BRIEF DESCRIPTION OF DRAWINGS

Fig. 1 is a schematic cross-sectional view illustrating a configuration of a thermoelectric conversion module according to a first embodiment.
Fig. 2 is a schematic cross-sectional view illustrating a configuration of the thermoelectric conversion module according to the first embodiment.
Fig. 3(A) is a diagram illustrating a temperature change of a lid of a manhole measured from May 22nd to May 30th, and Fig. 3(B) is a diagram illustrating a temperature change of a lid of a manhole measured from February 3rd to March 3rd.
Figs. 4(A) to 4(C) are schematic cross-sectional views for describing a problem of the present invention.
Figs. 5(A) to 5(C) are schematic cross-sectional views for describing operations and effects of the thermoelectric conversion module according to the first embodiment.
Fig. 6 is a schematic cross-sectional view illustrating a configuration of a thermoelectric conversion module according to a modified example of the first embodiment.
Fig. 7 is a schematic cross-sectional view illustrating a configuration of the thermoelectric conversion module according to the modified example of the first embodiment.
Fig. 8 is a schematic cross-sectional view illustrating a configuration of the thermoelectric conversion module according to the modified example of the first embodiment.

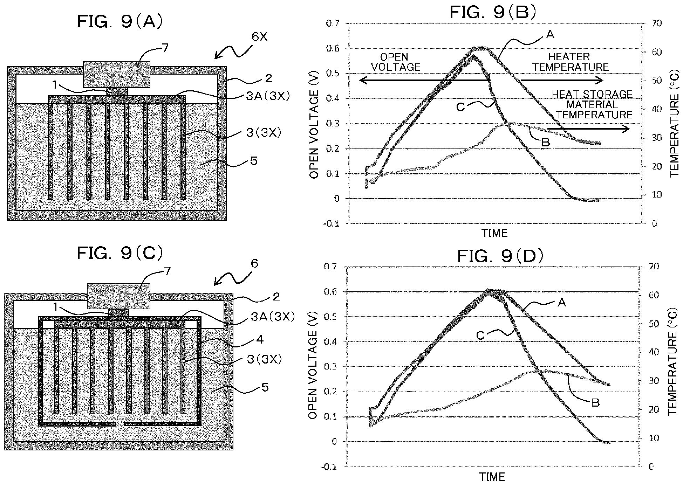

Figs. 9(A) to 9(D) are diagrams for describing effects of a thermoelectric conversion module of a first example, Fig. 9(A) is a schematic cross-sectional view illustrating a configuration of the thermoelectric conversion module of the first example, Fig. 9(B) is a diagram illustrating a temperature change of a heater, a temperature change of a heat storage material, and a change in an output voltage (open voltage) when the thermoelectric conversion module of the first example is used, Fig. 9(C) is a schematic cross-sectional view illustrating a configuration of the thermoelectric conversion module of a comparative example, and Fig. 9(D) is a diagram illustrating a temperature change of a heater, a temperature change of a heat storage material, and a change in an output voltage (open voltage) when the thermoelectric conversion module of the comparative example is used.
Fig. 10 is a schematic diagram illustrating a configuration of a sensor module according to a second embodiment.
Fig. 11 is a schematic diagram illustrating a configuration of an information processing system using the sensor module according to the second embodiment.
Fig. 12 is a schematic diagram illustrating a first application example of the sensor module and the information processing system according to the second embodiment.
Fig. 13 is a schematic diagram illustrating a second application example of the sensor module and the information processing system according to the second embodiment.
Fig. 14 is a schematic diagram illustrating a third application example of the sensor module and the information processing system according to the second embodiment.
Fig. 15 is a schematic diagram illustrating a fourth application example of the sensor module and the information processing system according to the second embodiment.
Fig. 16 is a schematic diagram illustrating a fifth application example of the sensor module and the information processing system according to the second embodiment.

### DESCRIPTION OF EMBODIMENTS

Hereinafter, a thermoelectric conversion module, a sensor module, and an information processing system according to embodiments of the present invention are described with reference to the appended drawings.

### [First Embodiment]

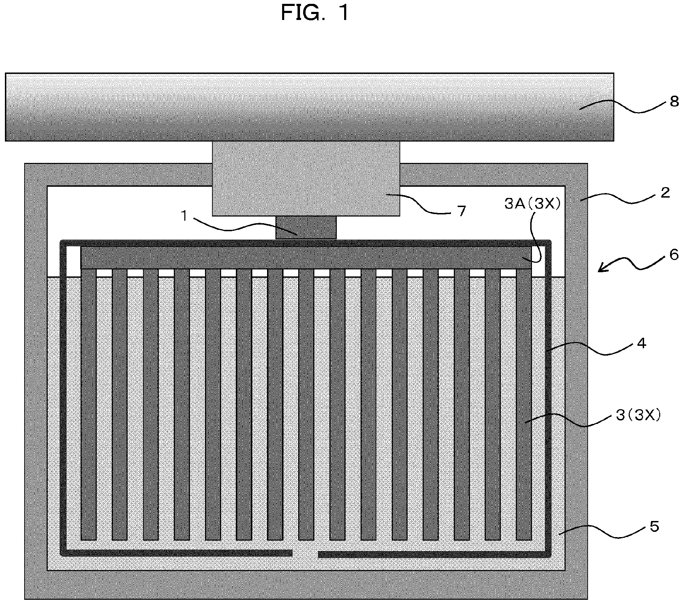

First, a thermoelectric conversion module according to the present embodiment will be described with reference to Figs. 1 to 9.

The thermoelectric conversion module according to the present embodiment is used for power generation using a thermoelectric conversion device capable of generating electric power when there is a temperature difference in the energy harvesting.

The thermoelectric conversion module of the present embodiment causes a temperature difference to occur between both sides of the thermoelectric conversion device using a heat storage material, and includes a thermoelectric conversion device 1, a container (a first container) 2, a fin 3, a heat dissipation member (a first heat dissipation member) 4, and a heat storage material (a first heat storage material) 5 as illustrated in Fig. 1.

The thermoelectric conversion device 1 is also referred to as a "thermoelectric conversion element", a "thermoelectric element" or a "thermoelectric device." A thermoelectric conversion module 6 is also referred to as a "thermoelectric module, " a "thermoelectric power generation module, " or a "power supplymodule." The fin 3 is also referred to as a "heat dissipation fin" or a "heat radiator (first heat radiator)." The heat dissipation member 4 is also referred to as a "heat radiator (second heat radiator)." Further, the container 2 is also referred to as a "heat storage material container."

Here, for example, the thermoelectric conversion device 1 has a structure in which a p-type thermoelectric material and an n-type thermoelectric material are alternately arranged and connected between two boards on which interconnections are formed. Further, the thermoelectric conversion device 1 is disposed such that one side thereof is a heat dissipation side, and a side opposite to one side is a heat source side. In other words, a heat radiator (the fin 3 and the heat dissipation member 4 to be described later) is thermally connected to one side of the thermoelectric conversion device 1, and a heat source 8 is thermally connected to a side opposite to one side.

For example, the container 2 is an insulating container (for example, a resin container) made of a heat insulating material such as resin. Thus, the heat storage material 5 disposed in the container 2 is insulated from the outside.

The fin 3 is thermally connected to one side of the thermoelectric conversion device 1 and has a higher thermal conductivity than the container 2 and extends in a direction away from the thermoelectric conversion device 1 in the container 2. Here, the fin 3 is disposed in a base portion 3A to protrude from the surface of the base portion 3A, and the fin 3 and the base portion 3A are entirely disposed in the container 2. Further, the base portion 3A does not come into contact with the heat storage material 5. Here, for example, the fin 3 and the base portion 3A are made of a high thermal conductivity material such as metal. In the present embodiment, the fin 3 and the base portion 3A are made of aluminum. Further, the fin 3 is assumed to include a pin as well. The fin 3 and base portion 3A are referred to collectively as a "heat sink 3X."

The heat dissipation member 4 is thermally connected to one side of the thermoelectric conversion device 1 and has a higher thermal conductivity than the fin 3 and extends up to a side (leading end side) far from the thermoelectric conversion device 1 of the fin 3in the container 2. Here, the heat dissipation member 4 is disposed to surround the fin 3. In the present embodiment, the heat dissipation member 4 is entirely disposed in the container 2 and disposed to cover the fin 3 and the base portion 3A entirely. The heat dissipation member 4 comes into contact with the surface on one side of the thermoelectric conversion device 1 and extends up to the heat storage material 5 on a side far from the thermoelectric conversion device 1 of the fin 3.

In the present embodiment, since the aluminum fin 3 is used, a graphite sheet is used as the heat dissipation member 4 having a higher thermal conductivity than the fin 3. Here, a thermal conductivity of aluminum is about 238 W/m*K (since an aluminum alloy is commonly used, a thermal conductivity is equal to or less than it), whereas a thermal conductivity of the graphite sheet is about 500 to about 1, 500 W/m*K, that is more than twice.

In the present embodiment, the fin 3 is made of aluminum, and the heat dissipation member 4 is made of the graphite sheet, but the present invention is not limited to this example. For example, the fin 3 may be made of aluminum, and the heat dissipation member 4 may be a silver sheet (silver foil) or a copper sheet (copper foil) . Here, the thermal conductivity of silver is about 420 W/m*K, and the thermal conductivity of copper is about 398 W/m*K. Further, for example, the fin 3 may be made of copper, and the heat dissipation member 4 may be a silver sheet (silver foil) or a graphite sheet. For example, the fin 3 may be made of iron, and the heat dissipation member 4 may be made of a graphite sheet, an aluminum sheet (aluminum foil), a silver sheet (silver foil), or a copper sheet (copper foil). Here, the thermal conductivity of iron is about 84 W/m*K. As described above, aluminum, copper, iron, or the like can be used as a material of the fin 3, and graphite, silver, copper, aluminum, or the like can be used as a material of the heat dissipation member 4.

The heat storage material 5 is disposed in the container 2 and thermally connected to the fin 3 and the heat dissipation member 4. Here, the fin 3 and the heat dissipation member 4 are partially immersed in the heat storage material 5 disposed in the container 2.

Here, the heat storage material 5 is a latent heat storage material (Phase Change Material; PCM), and for example, inorganic hydrated salt, inorganic salt, metal, water (a chemical formula H₂O: a melting point 0°C, and latent heat of fusion of 336 kJ/kg), an organic compound, or the like can be used.

Examples of the inorganic hydrated salt include a calcium chloride hydrate (a chemical formula: CaCl₂·6H₂O: a melting point: 28.7°C and latent heat of fusion: 192 kJ/kg), a sodium sulfate hydrate (a chemical formula Na₂SO₄·10H₂O: a melting point 32.4°C and latent heat of fusion: 251 kJ/kg), a sodium thiosulfate hydrate (a chemical formula Na₂S₂O₄·5H₂O: a melting point 48°C and latent heat of fusion: 197 kJ/kg), and a sodium acetate hydrate (a chemical formula CH₃COOH·3H₂O: a melting point 58°C and latent heat of fusion: 264 kJ/kg). Further, an example of the inorganic salts includes sodium chloride (a chemical formula NaCl: a melting point 800°C and latent heat of fusion 483 kJ/kg). Further, an example of metal includes aluminum (a chemical formula Al: a melting point 661°C and latent heat of fusion 397 kJ/kg). Further, examples of the organic compound include paraffin (a chemical formula CₙH₂ₙ₊₂: a melting point -30°C to 45°C and latent heat of fusion 150 to 250 kJ/kg) and erythritol (a chemical formula C₄H₁₀O₄: a melting point 118°C and latent heat of fusion 314 kJ/kg).

In the present embodiment, further, a heat transfer member 7 which is disposed in the container 2 and has a higher thermal conductivity than the container 2 is provided. For example, the heat transfer member 7 is made of a high thermal conductivity material such as metal. The thermoelectric conversion device 1 is disposed in the container 2, and a side opposite to one side, that is, a side opposite to the side to which the fin 3 and the heat dissipation member 4 are thermally connected is thermally connected to the heat transfer member 7. The heat transfer member 7 is also referred to as a "heat transfer part."

Here, the heat transfer member 7 is disposed in an opening portion of the container 2, and the heat transfer member 7 is thermally connected to the external heat source 8. Heat from the heat source 8 outside the container is transferred to the thermoelectric conversion device 1 via the heat transfer member 7, transferred to the fin 3 and the heat dissipation member 4 via the thermoelectric conversion device 1, and then dissipated from the fin 3 and the heat dissipation member 4 to the heat storage material 5.

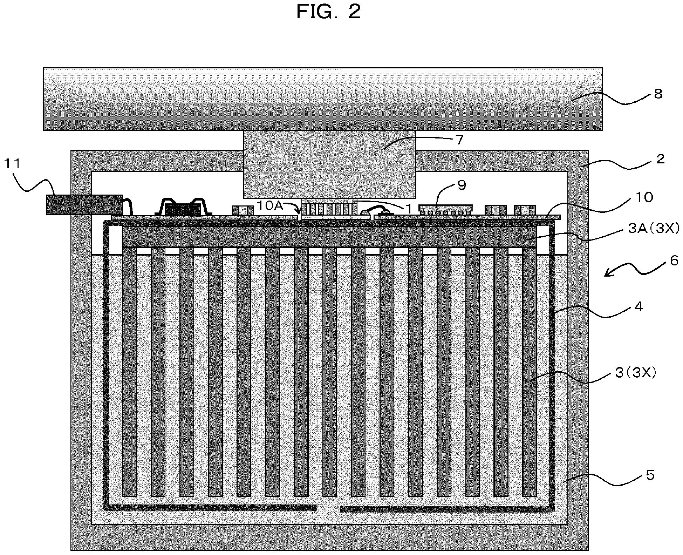

More specifically, in the present embodiment, a board 10 that has an opening portion 10A and includes electronic parts 9 mounted thereon is provided as illustrated in Fig. 2. The thermoelectric conversion device 1 is disposed in the opening portion 10A of the board 10 and electrically connected to the board 10. Further, the board 10 is connected to an external connection terminal 11. The board 10 is also referred to as a "circuit board."

Particularly, in the present embodiment, as described above, as the heat radiator for transferring heat from thermoelectric conversion device 1 to the heat storage material 5, in addition to the fin 3, the heat dissipation member 4 having a higher thermal conductivity than the fin 3 is disposed. In other words, two types of heat radiators 3 and 4 having different thermal conductivities are used as the heat radiator used for radiating the heat from the thermoelectric conversion device 1 to the heat storage material 5.

At least a portion of the heat dissipation member 4 which is a heat radiator having a high thermal conductivity is disposed to be located around the fin 3 which is the heat radiator having a lower thermal conductivity than the heat dissipation member 4.

Further, the heat dissipation member 4 which is a heat radiator having a high thermal conductivity is arranged to transfer heat to the heat storage material 5 located at a position farther away from the heat source 8 than the fin 3 which is a heat radiator having a lower thermal conductivity than the heat dissipation member 4.

Here, the graphite sheet 4 and the aluminum heat sink 3X are connected to the surface of one side of the thermoelectric conversion device 1 in the described order, for example, via a heat dissipation grease, and at least portions of the graphite sheet 4 and the aluminum fin 3 are immersed in the heat storage material 5. The graphite sheet 4 is disposed to reach the heat storage material 5 located at a position farther away from the thermoelectric conversion device 1 than a leading end of the aluminum fin 3.

Thus, the heat from the heat source 8 is dispersed and transferred to the heat storage material 5. As a result, it is possible to perform highly efficient power generation and increase the power generation amount (generated electric energy) as compared with the case where only the fin 3 is disposed. In other words, since two types of heat radiators 3 and 4 having different thermal conductivities are used, the heat transferred to the heat storage material 5 is efficiently dispersed although the heat quantity is the same, and the heat storage material 5 is melted more uniformly as compared with the case where one type of heat radiator 3 is used. In other words, the latent heat use efficiency of the heat storage material 5 is increased. Accordingly, sensible heating, that is, a phenomenon that the temperature of the heat storage material increases to a temperature equal to or higher than the melting point due to the sensible heat is delayed, the temperature difference is secured, and more power generation amount is obtained from the thermoelectric conversion device 1.

Therefore, it is possible to generate electric power regardless of day and night using the thermoelectric conversion device 1 in an environment in which the temperature difference is reversed between one side of a structure and the other side in day and night as in a manhole.

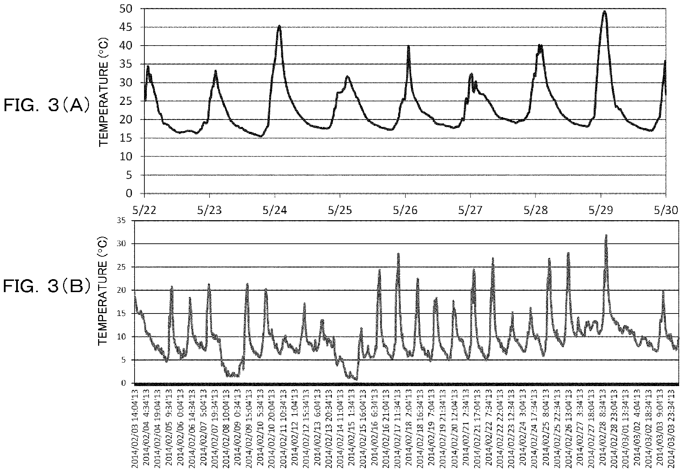

For example, the temperature of the lid of the manhole varies with the seasons, but it periodically varies with substantially the same amplitude when it is observed weekly or monthly. On sunny days, a difference between a maximum value and a minimum value is considerably large, for example, 25 to 30°C in the summer and 15 to 20°C in the winter. Here, Fig. 3(A) illustrates a temperature change of the lid of the manhole measured from May 22^{nd} to May 30^{th}, and Fig. 3(B) illustrates a temperature change of the lid of the manhole measured February 3^{rd} to March 3^{rd}.

In a case where the lid of the manhole in which such a periodic temperature change is repeated is the heat source, it is an optimal choice to use the heat storage material on a cooling side (a heat dissipation side) . In this case, when the heat storage material having a melting point at a temperature which is the middle of the maximum value and the minimum value of the periodic temperature change of the lid of the manhole is used, it is possible to use a latent heat quantity of the heat storage material by repeating melting and solidification with one day cycle.

In the thermoelectric power generation using the temperature of the lid of the manhole, the power generation using the temperature difference between the temperature of the lid of the manhole and the temperature inside the manhole may be considered, but in the power generation using only the heat sink without using the heat storage material, a temperature difference occurring in the thermoelectric conversion device is much smaller than the temperature difference between the temperature of the lid of the manhole and the temperature inside the manhole. For this reason, only a small amount of power is generated. On the other hand, when the heat storage material is used on the cooling side, the temperature difference occurring in the thermoelectric conversion device is the temperature difference between the temperature of the lid of the manhole and the temperature of the heat storage material, and the temperature difference is large, and thus a large amount of power is obtained. For example, it is possible to obtain a sufficient power generation amount needed for a manhole sensor in which data transmission based on wireless communication is assumed. Further, it is possible to obtain a large power generation amount without aging deterioration.

Meanwhile, the reason for employing the above-described configuration is as follows.

The thermoelectric conversion device is mainly configured with a plurality of p-type thermoelectric semiconductors and a plurality of n-type thermoelectric semiconductors and has a function of directly converting thermal energy to electric energy and converting electric energy to thermal energy. If a temperature difference occurs between both sides of the thermoelectric conversion device, a voltage is generated by seebeck effect. The thermoelectric power generation device extracts this voltage as the electric energy.

Direct energy conversion from thermal energy into electric energy is able to be performed through the thermoelectric power generation device, and it attracts attention as one of effective thermal energy utilization methods represented by waste heat utilization.

A general thermoelectric conversion device has a structure in which a thermocouple is constituted by both end portions of a p-type thermoelectric semiconductor and an n-type thermoelectric semiconductor of a columnar shape having substantially the same length as a pair, a plurality of thermocouples are arranged in a planar form, the p-type thermoelectric semiconductor and the n-type thermoelectric semiconductor are alternately arranged in a regular manner, and the thermocouples are electrically connected in series.

Interconnections to be electrically connected are formed on two boards made of, for example, silicon (Si) or a ceramic material, and these board has a structure facing each other with a space corresponding to a thickness of the p-type thermoelectric semiconductors/the n-type thermoelectric semiconductors and an electrode connecting them.

When one board is brought into contact with the heat source, and heat is dissipated from the other board, a temperature difference occurs between a pair of thermoelectric semiconductors. In order to cause the temperature difference to occur continually, a heat dissipation part is attached to the board on the heat dissipation side.

In the case of natural air cooling, a heat sink in which an aluminum oxide film is formed on the surface by performing an anodizing process on aluminum is commonly used as a heat dissipation part.

The power generation performed by the thermoelectric conversion device is able to be performed at any place having a temperature difference, but since it depends on a naturally occurring temperature, it relies on nature entirely.

For example, in a case where a concrete, metal, or the like warmed by solar heat is selected as a heat source, and a thermoelectric conversion device is mounted on it, heat from the heat source is dissipated to the air via a heat sink, and electric power is generated by causing a temperature difference through the thermoelectric conversion device.

However, in the thermoelectric conversion module, although the surface area of the fin of the heat sink is large, it is difficult to cause a side on which the heat sink of the thermoelectric conversion device is disposed to have the same temperature as the outside temperature.

For this reason, a temperature difference occurring between upper and lower surfaces of the thermoelectric conversion device is smaller than a temperature difference between the outside temperature and the high temperature heat source. Therefore, the power generation amount generated by the thermoelectric conversion module is also small.

Further, the thermoelectric conversion module, a temperature difference may be caused to occur by the thermoelectric conversion device using a temporal change in the temperature of the heat source. In such a thermoelectric conversion module, the heat source is brought into contact with one side of the thermoelectric conversion device, and a heat storage material is brought into contact with the other side. A temperature of the heat source used in this case is not constant, and a change in the temperature over time is used.

For example, a motor or a boiler that intermittently repeats an operation and a dormant state is used as the heat source. Alternatively, a thing which is left outside such as an outer wall or a roof of a building or an engine, an exterior, or the like of a vehicle is used as the heat source using a temperature change between day and night.

Here, the heat storage material is an organic or inorganic material, but a material which is commonly used is a saturated hydrocarbon type organic material which is relatively easy to handle. The melting point has various temperatures ranging from -30°C to 40°C, and an application to building materials is under review in addition to an application to air cooling.

Further, the heat storage material has a property of keeping a constant temperature since a change of phase is caused by the material. For this reason, as the temperature of the heat source changes over time, the temperature difference with the heat source occurs, and the thermoelectric conversion device generates electric power in accordance with the temperature difference.

In this case, a quantity of heat flowing into the thermoelectric conversion device and a quantity of heat flowing out of the thermoelectric conversion device in association with a temporal change in the temperature of the heat source are estimated, and it is desirable that the heat quantities be smaller than a latent heat quantity of the heat storage material, and it is a condition under which a temperature difference is caused to occur between the upper and lower surfaces of the thermoelectric conversion device consistently.

The heat storage material is melted by heat transferred from the heat source via the thermoelectric conversion device, but the heat storage material has a property of keeping a constant temperature until it is completely melted. For this reason, in a case where heat exchange with a non-heat source is considered to be ignorable in the entire thermoelectric conversion module, if an integrated value of the quantity of the heat flowing into the heat storage material from the heat source via the thermoelectric conversion device reaches the latent heat quantity of the heat storage material, the heat storage material is completely melted. Therefore, if the latent heat quantity of the heat storage material is exceeded, the heat storage material is completely melted, and it is difficult to cause a temperature difference to occur between the upper and lower surfaces of the thermoelectric conversion device.

In this type of thermoelectric conversion module, a temperature difference is caused to occur between the upper and lower surfaces of the thermoelectric conversion device using heat transfer between the heat storage material and the thermoelectric conversion device or between the heat source surface and the thermoelectric conversion device. Therefore, it is possible to reliably cause a temperature difference to occur as compared with a thermoelectric conversion module of a type using heat transfer with the external air.

However, it is commonly known that the heat storage material has a very low thermal conductivity, and a representative value is 0.1 W/mK to 0.5 W/mK. For this reason, in a case where the heat storage material is merely brought into contact with the thermoelectric conversion device, a portion of the heat storage material adjacent to the thermoelectric conversion device is repeatedly melted and solidified. As a result, heat is not transferred to a portion of the heat storage material which is at a distance away from the thermoelectric conversion device, and it is difficult to derive the performance of the entire heat storage material.

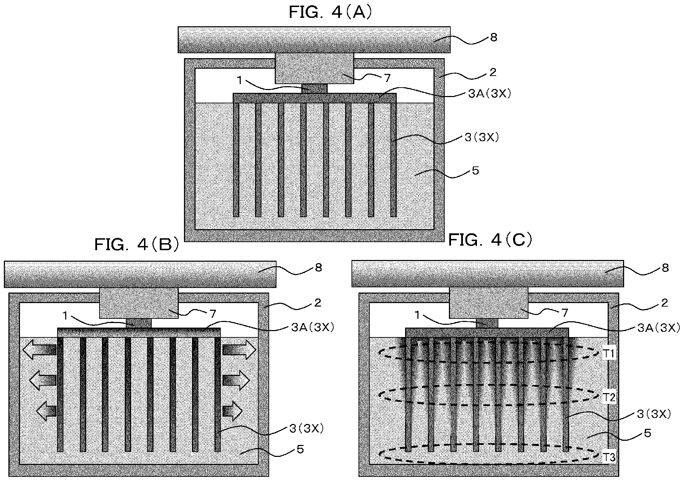

In this regard, for example, in the thermoelectric conversion module illustrated in Fig. 4(A), the fin 3 of the metallic heat sink 3X including the fin 3 and the base portion 3A is inserted into the heat storage material 5, and thus the efficiency of the heat transfer with the heat storage material 5 is improved. The fin 3 is brought into contact with the thermoelectric conversion device 1, and a plurality of fins 3 are inserted into the heat storage material 5 in parallel. More specifically, the fins 3 are inserted into the heat storage material 5 downwards with a predetermined depth. Since the fins 3 are inserted into the heat storage material 5 as described above, melting of the heat storage material 5 progresses from the upper surface side to the lower side along the fins 3. Accordingly, the heat storage material 5 is melted in a wider area.

However, an intrinsic problem remains even when heat is transferred to the heat storage material 5 using the heat sink 3X including the fin 3, via the fin 3.

In other words, since the heat storage material 5 has a low thermal conductivity and poor fluidity, the melting of the heat storage material 5 starts from a portion around the fin 3, but before the melting expands and spreads to the entire the heat storage material 5, the temperature starts to increase from a portion around the fin 3, and the temperature of the heat storage material 5 increases to be the melting point or more (the sensible heating). Until the melting is completed, the temperature of the heat storage material 5 maintains the melting point using the latent heat, and power generation of obtaining large electric power using the temperature difference between the melting point and the heat source, but since the temperature increases from a portion around the fin 3, only an amount of electric power smaller than an expected power generation amount is generated. For example, a power generation amount which is actually obtained is about 30 to 40% lower than a power generation amount expected to be obtained when 100% of the latent heat quantity of the heat storage material 5 is used.

Further, as illustrated in Fig. 4(B), the temperature of the heat sink 3X increases from the side close to the heat source 8, but the heat storage material 5 which is in direct contact with the heat sink 3X draws heat from the heat sink 3X. Since a thermal conductivity of the heat storage material 5 is about 10 times as high as the air as compared with a case where the air is around the heat sink 3X, a time in which heat is transferred from the heat source 8 side of the fin 3 of the heat sink 3X to the leading end is delayed. In other words, since the sensible heating in the heat storage material 5 around the fin 3 on the side close to the heat source 8 is faster than that in the leading end, the temperature difference between the heat sink 3X and the heat storage material 5 is small, and further, it reaches the leading end, a power generation amount (open voltage) is unable to be obtained.

In this case, as illustrated in Fig. 4(C), if the temperature of the heat storage material 5 on the side of the base portion 3A of the heat sink 3X, that is, the temperature of the heat storage material 5 near the surface is indicated by T1, the temperature of the heat sink 3X around an intermediate portion of the fin 3 of the heat sink 3X, that is, the temperature of the heat storage material 5 of the intermediate portion is indicated by T2, and the temperature of the heat storage material of the leading end side of the fin 3 of the heat sink 3X, that is, the temperature of the heat storage material 5 near the bottom is indicated by T3, the temperature T3 of the heat storage material 5 near the bottom hardly increases, whereas the temperature T1 of the heat storage material 5 near the surface is very high.

In this regard, in order to increase the temperature difference which is able to be caused by the thermoelectric conversion device so that the heat is transferred to the heat storage material 5 on the side far from the thermoelectric conversion device 1 of the fin 3 and increase the power generation amount, the above configuration is employed.

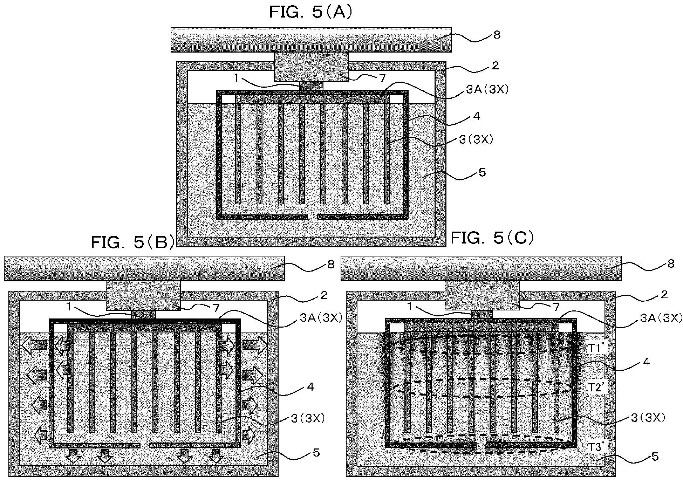

Particularly, as illustrated in Fig. 5 (A), in addition to the fin 3, the heat dissipation member 4 having a higher thermal conductivity than the fin 3 is disposed as the heat radiator for transferring the heat from the thermoelectric conversion device 1 to the heat storage material 5. Further, the heat dissipation member 4 is arranged so that the heat is transferred to the heat storage material 5 located at a position farther from the heat source 8 than the fin 3. For this reason, as illustrated in Fig. 5 (B), the heat from the heat source 8 is dispersed and transferred to the heat storage material 5 as compared with the configuration which only the fin 3 is disposed [see Figs. 4(A) and 4(B)].

In this case, as illustrated in Fig. 5(C), if the temperature of the heat storage material 5 on the side of the base portion 3A of the heat sink 3X, that is, the temperature of the heat storage material 5 near the surface is indicated by T1', the temperature of the heat sink 3X around an intermediate portion of the fin 3 of the heat sink 3X, that is, the temperature of the heat storage material 5 of the intermediate portion is indicated by T2', and the temperature of the heat storage material of the leading end side of the fin 3 of the heat sink 3X, that is, the temperature of the heat storage material 5 near the bottom is indicated by T3', the temperature T1' of the heat storage material 5 near the surface hardly increases, and the temperature T3' of the heat storage material 5 near the bottom also increases. In other words, as compared with the configuration which only the fin 3 is disposed [see Figs. 4 (A) and 4(B)], the temperature T1' of the heat storage material 5 near the surface is lower (T1' < T1), and the temperature T3' of the heat storage material 5 near the bottom is higher (T3' > T3).

Thus, since the heat dissipation member 4 having a higher thermal conductivity than the fin 3 is disposed in addition to the fin 3, and the heat dissipation member 4 is disposed so that the heat is able to be transferred to the heat storage material 5 located at a position farther away from the heat source 8 than the fin 3, it is possible to efficiently disperse the heat from the heat source 8 and melt the heat storage material 5 more uniformly as compared with the configuration which only the fin 3 is disposed [see Figs. 4 (A) and 4(B)]. Accordingly, the phenomenon that the temperature of the heat storage material increases to a temperature equal to or higher than the melting point due to the sensible heat is delayed, the temperature difference is secured, and a more power generation amount is obtained from the thermoelectric conversion device.

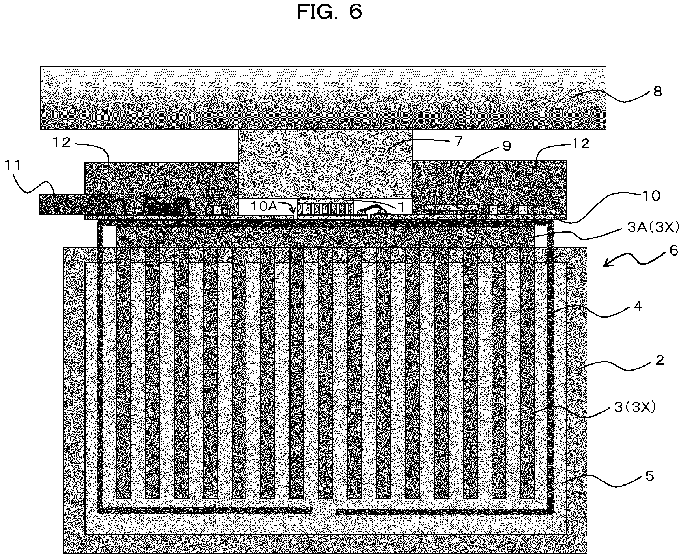

Further, since the base portion 3A of the heat sink 3X is closest to the heat source 8 and has a volume, more heat is accumulated, and if the base portion 3A comes into contact with the heat storage material 5, the melting starts from the heat storage material 5 which is in contact with the base portion 3A, and the sensible heating is immediately performed, leading to the increase in the temperature. For this reason, as illustrated in Fig. 1, in the present embodiment, a gap is formed so that the base portion 3A does not come into contact with the heat storage material 5. However, the present invention is not limited to this example, and for example, a resin plate or the like may be inserted between the base portion 3A and the heat storage material 5 as a heat insulating material (for example, see Fig. 6).

Therefore, according to the thermoelectric conversion module of the present embodiment, the heat is also transferred to the heat storage material 5 on the side far from the thermoelectric conversion device 1 of the fin 3, and thus there is an advantage in that it is possible to increase the temperature difference which is able to be caused by the thermoelectric conversion device 1 and increase the power generation amount.

In other words, since it is possible to disperse and dissipate the heat from the thermoelectric conversion device 1 in the heat storage material 5, it is possible to increase the temperature difference to be larger than in the configuration having only the heat sink 3X and increase the power generation amount, and thus it is possible to implement the efficient power generation. Further, since a change in melting and solidification of the heat storage material 5 progresses uniformly, it is also possible to implement the high-performance thermoelectric conversion module 6.

In the above embodiment, the heat transfer member 7 is disposed in the container 2, the thermoelectric conversion device 1 is disposed in the container 2, and the side opposite to one side is thermally connected to the heat transfer member 7, but the present invention is not limited to this example.

For example, the heat transfer member 7 may be disposed the container (first container) 2, the thermoelectric conversion device 1 may be disposed outside the container 2, and the side opposite to one side is thermally transferred to the heat transfer member 7 as illustrated in Fig. 6. In other words, the heat transfer member 7 and the thermoelectric conversion device 1 may be disposed outside the container 2, and the fin 3 and the heat dissipation member 4 may be partially inserted and immersed in the heat storage material 5 disposed in the container 2. Here, the base portion 3A of the heat sink 3X is disposed outside the container 2. Further, the board 10 on which the thermoelectric conversion device 1 is disposed is also disposed outside the container 2, but in this case, it is preferable to seal with a sealing material 12 so that a space is formed around the thermoelectric conversion device 1. Further, in the above embodiment, similarly, sealing may be performed with a sealing material so that a space is formed around the thermoelectric conversion device 1.

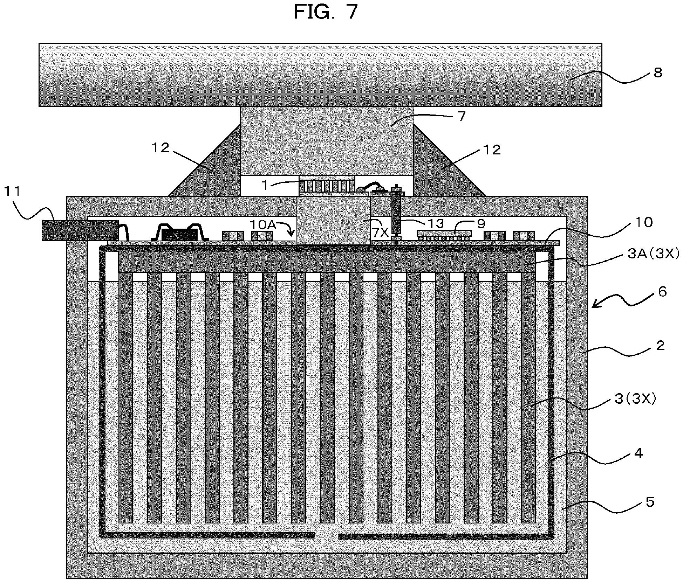

Further, for example, a first heat transfer member 7X having a higher thermal conductivity than the container 2 may be disposed in the container 2 (first container), a second heat transfer member 7 may be disposed outside the container 2, the thermoelectric conversion device 1 may be disposed outside the container 2, one side may be thermally connected to the fin 3 (the heat sink 3X) and the heat dissipation member 4 (the first heat dissipation member) via the first heat transfer member 7X, and a side opposite to one side may be thermally connected to the second heat transfer member 7 as illustrated in Fig. 7. In other words, in the above embodiment, the thermoelectric conversion device 1 and the heat transfer member 7 may be disposed outside the container 2, and one side of the thermoelectric conversion device 1 may be thermally connected with the fin 3 and the heat dissipation member 4 via another heat transfer member 7X. In this case, the first heat transfer member 7X may be disposed in an opening portion 10A of the board 10 disposed in the container 2, and the thermoelectric conversion device 1 may be electrically connected to the board 10 via, for example, a connector 13. Further, it is preferable to seal with the sealing material 12 so that a space is formed around the thermoelectric conversion device 1 interposed between the first heat transfer member 7X and the second heat transfer member 7. Further, the second heat transfer member 7 is thermally connected to the heat source 8. The first heat transfer member 7X is also referred to as a "heat dissipation side heat transfer member," and the second heat transfer member 7 is also referred to as a "heat source side (heat absorption side) heat transfer member."

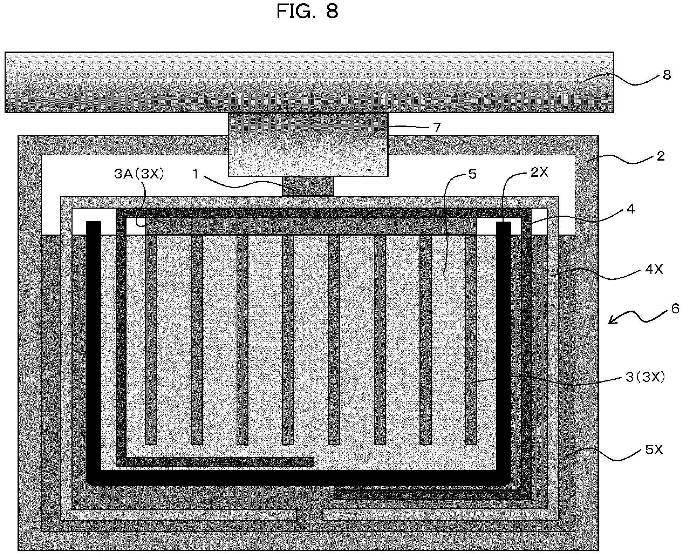

Further, in the above embodiment, a second heat dissipation member 4X which is thermally connected to one side of the thermoelectric conversion device 1, has a higher thermal conductivity than the fin 3, has a different thermal conductivity from the first heat dissipation member 4, and extends up to a side far from the thermoelectric conversion device 1 of the fin 3 in the container 2 may be disposed (for example, see Fig. 8) . In other words, at least two heat dissipation members 4 and 4X having different thermal conductivities may be disposed as the heat dissipation member. In this case, at least two heat dissipation members 4 and 4X may be made of materials having different thermal conductivities.

In this case, for example, a second container 2X which is disposed in the first container 2 and includes the fin 3, the first heat dissipation member 4, and the first heat storage material 5 disposed therein and a second heat storage material 5X which is disposed in the first container 2 and outside the second container 2X and thermally connected to at least the second heat dissipation member 4X, and has a melting point different from that of the first heat storage material 5 may be disposed as illustrated in Fig. 8. In other words, at least two heat dissipation members 4 and 4X having different thermal conductivities may be disposed as the heat dissipation member, and at least two types of heat storage materials 5 and 5X having different melting points may be disposed as the heat storage material. For example, if the thermal conductivity of the fin 3 is indicated by λ1, the thermal conductivity of the first heat dissipation member 4 is indicated by λ2, and the thermal conductivity of the second heat dissipation member 4X is indicated by λ3, it is desirable that λ1 < λ2 > λ3 (λ1 < λ3 < λ2) be satisfied. Further, for example, if the melting point of the first heat storage material 5 is indicated by Tₘ1, and the melting point of the second heat storage material 5X is indicated Tₘ2, it is desirable that Tₘ1 ≠ Tₘ2 be satisfied. Further, one end side of the first heat dissipation member 4 may be immersed in the first heat storage material 5, the other end side may be immersed in the second heat storage material 5X, and the second heat dissipation member 4X may be immersed in the second heat storage material 5X. Thus, when the first heat dissipation member 4 and the second heat dissipation member 4X are immersed in the first and second heat storage materials 5 and 5X having different melting points, and the difference between the melting points of the first and second heat storage materials 5 and 5X are used, it is possible to perform the power generation for a longer time in accordance with the temperature of the day or each season.

### [Examples]

Next, examples for describing the present invention more specifically will be described. The present invention is not limited to the following examples.

### [First Example]

In the present first example and a comparative example, GKB10 manufactured by YAMAHA was used as the thermoelectric conversion device constituting the thermoelectric conversion module, 100 g of Ecojoule TS8 (a melting point 26°C and a latent heat of fusion 250 kJ/kg) manufactured by JXTG Nippon Oil & Energy was used as the heat storage material, N60-40B (a pin type heat sink: size 60 × 60 × 40 mm) which is a heat sink made of aluminum and manufactured by Alpha industries Inc. was used as the heat sink, a PGS graphite sheet (a thickness 100 µm and a size 60 × 100 mm) manufactured by Panasonic Corporation was used as the heat dissipation member, an aluminum member was used as the heat transfer member, and Tupperware made of resin was used as the container.

The thermoelectric conversion module 6 of the present first example was manufactured such that the aluminum heat sink 3X was connected to one side of the thermoelectric conversion device 1 with the graphite sheet 4 interposed therebetween, the fin 3 of the aluminum heat sink 3X and the graphite sheet 4 were partially immersed in the heat storage material 5 provided in the Tupperware serving as the container 2, and the side opposite to one side of the thermoelectric conversion device 1 was connected to the aluminum member serving as the heat transfer member 7 attached to the Tupperware 2 as illustrated in Fig. 9(C).

Further, as illustrated in Fig. 9(A), the thermoelectric conversion module 6X of the comparative example was manufactured such that the aluminum heat sink 3X was connected to one side of the thermoelectric conversion device 1 with no graphite sheet interposed therebetween, the fin 3 of the aluminum heat sink 3X was partially immersed in the heat storage material 5 disposed in the Tupperware serving as the container 2, and the side opposite to one side of the thermoelectric conversion device 1 is connected to the aluminum member serving as the heat transfer member 7 attached to the Tupperware 2.

Then, the thermoelectric conversion device 1 was heater-heated via the aluminum member serving as the heat transfer member 7. In the heater heating, a heating profile in which the temperature was increased from the room temperature to 60°C for four hours, it is maintained at 60°C for half an hour, and the temperature was decreased up to the room temperature for four hours was used.

Here, Fig. 9(D) illustrates a change in a temperature of a heater, a change in a temperature of a heat storage material, and a change in an open voltage (output voltage) in the case of the thermoelectric conversion module 6 (with a graphite sheet) of the present first example. Further, Fig. 9(B) illustrates a change in a temperature of a heater, a change in a temperature of a heat storage material, and a change in an open voltage (output voltage) in the case of the thermoelectric conversion module 6X (with no graphite sheet) of the comparative example. In Figs. 9(D) and 9(B), the temperature change of the heater is indicated by a solid line A, the temperature change of the heat storage material is indicated by a solid line B, and the change in the open voltage is indicated by a solid line C.

As illustrated in Fig. 9(D), in the case of the thermoelectric conversion module 6 of the present first example, as compared with the thermoelectric conversion module 6X of the comparative example, a maximum value of the output voltage was increased from about 0.57 V to about 0.61V, the temperature change of the heat storage material 5 was delayed and overall shifted rightwards, a temperature difference ΔT between the temperature of the heater and the temperature of the heat storage material 5 was increased in all time, and the power generation amount was increased by about 15%.

### [Second Example]

In a second example, KTG5066A00 manufactured by KELK Ltd was used as the thermoelectric conversion device 1 constituting the thermoelectricconversionmodule 6, 50 gof Ecojoule TS20 (amelting point 36.9°C and a latent heat of fusion 249 kJ/kg) manufactured by JXTG Nippon Oil & Energy was used as the heat storage material 5, N50-25B (a pin type heat sink: size 50 × 50 × 25 mm) which is a heat sink made of aluminum and manufactured by Alpha industries Inc. was used as the heat sink 3X, a PGS graphite sheet (a thickness 100 µm and a size 50 × 80 mm) manufactured by Panasonic Corporation was used as the heat dissipation member 4, an aluminum member was used as the heat transfer member 7, and Tupperware made of resin was used as the container 2 [see Fig. 9(D)].

Further, the thermoelectric conversion module 6 of the present second example was attached to a drain pipe of a factory in which hot water and cold water are alternately circulated, and data was acquired from a temperature/humidity sensor, a gas sensor, or the like in the factory and used as a power source for wireless communication. Here, the temperature of the hot water was 80°C, the temperature of the cold water was 20°C, and they were discharged alternately for about 10 minutes at intervals of one hour.

As a result, in the thermoelectric conversion module 6 of the present second example, an output voltage was a maximum of 0.8 V, and it was possible to secure the temperature difference between the temperature (melting point) of the heat storage material 5 and the temperature of the hot water and obtain the sufficient power generation amount.

### [Third Example]

In a third example, GKB10 manufactured by YAMAHA was used as the thermoelectric conversion device 1 constituting the thermoelectric conversion module 6, 100 g of Patthermo F15 (a melting point 15.1°C and a latent heat of fusion 190 kJ/kg) manufactured by Kaneka Corporation or 100 g of Ecojoule TS9 (a melting point 30°C and a latent heat of fusion 184 kJ/kg) manufactured by JXTG Nippon Oil & Energy was used as the heat storage material 5, N60-40B (a pin type heat sink: size 60 × 60 × 40 mm) which is a heat sink made of aluminum and manufactured by Alpha industries Inc. was used as the heat sink 3X, a PGS graphite sheet (a thickness 100 µm and a size 60 × 100 mm) manufactured by Panasonic Corporation was used as the heat dissipation member 4, an aluminum member was used as the heat transfer member 7, and Tupperware made of resin was used as the container 2 [see Fig. 9(D)].

Further, the thermoelectric conversion module 6 of the present third example was attached to a back side of a lid of a manhole of a sewer pipe installed on a road, and an amount of sewage water, an amount of corrosive gas, a temperature in the pipe, or the like was sensed and used as a power source for wireless transmission.

Here, since the temperature of the lid of the manhole was around 25°C to 60°C in the summer in the heart of Tokyo, around 5°C to 25°C in the winter, the two types of heat storage materials 5 described above were used as the heat storage material. In other words, in the summer, the thermoelectric conversion module 6 including 100 g of Ecojoule TS9 (a melting point 30°C and a latent heat of fusion 184 kJ/kg) manufactured by JXTG Nippon Oil & Energy was used as the heat storage material 5, and in the winter, the thermoelectric conversion module 6 including 100 g of Patthermo F15 (a melting point 15.1°C and a latent heat of fusion 190 kJ/kg) manufactured by Kaneka Corporation was used as the heat storage material 5.

As a result, in the thermoelectric conversion module 6 of the present third example, the output voltage was a maximum of 0.6 V in the summer and a maximum of 0.2 V in the winter, and it was possible to secure the temperature difference between the temperature (melting point) of the heat storage material 5 and the temperature of the lid of the manhole and obtain the sufficient power generation amount.

### [Fourth Example]

In a fourth example, GKB10 manufactured by YAMAHA was used as the thermoelectric conversion device 1 constituting the thermoelectric conversion module 6, 100 g of Patthermo F15 (a melting point 15.1°C and a latent heat of fusion 190 kJ/kg) manufactured by Kaneka Corporation was used as the first heat storage material 5, 100 g of Ecojoule TS9 (a melting point 30°C and a latent heat of fusion 184 kJ/kg) manufactured by JXTG Nippon Oil & Energy was used as the second heat storage material 5X, N60-40B (a pin type heat sink: size 60 × 60 × 40 mm) which is a heat sink made of aluminum and manufactured by Alpha industries Inc. was used as the heat sink 3X, a PGS graphite sheet (a thickness 100 µm and a size 60 × 200 mm) manufactured by Panasonic Corporation was used as the first heat dissipation member 4, an Ag sheet (a thickness 100 µm and a size 60 × 200 mm) was used as the second heat dissipation member 4X, an aluminum member was used as the heat transfer member 7, and resin containers were used as the first container 2 and the second container 2X [see Fig. 8].

In this case, the second container 2X including the first heat storage material 5 disposed therein was inserted in the first container 2, and the second heat storage material 5X was disposed in the first container 2 and outside the second container 2X. In other words, a nested structure in which the second container 2X including the first heat storage material 5 disposed therein is inserted in the first container 2 including the second heat storage material 5X disposed therein was employed. Since the resin container was used as the second container 2X, the first heat storage material 5 and the second heat storage material 5X were substantially insulated. Then, the fin 3 of the aluminum heat sink 3X was partially immersed in the first heat storage material 5, the Ag sheet serving as the second heat dissipation member 4X was partially immersed in the second heat storage material 5X, the graphite sheet serving as the first heat dissipation member 4 was partially immersed in both the first heat storage material 5 and the second heat storage material 5X, and the heat from the thermoelectric conversion device 1 was transferred to the first heat storage material 5 and the second heat storage material 5X via the aluminum heat sink 3X, the Ag sheet 4X, and the graphite sheet 4.

Further, the thermoelectric conversion module 6 of the present fourth example was attached to a back side of a lid of a manhole of a sewer pipe installed on a road, and an amount of sewage water, an amount of corrosive gas, a temperature in the pipe, or the like was sensed and used as a power source for wireless transmission.

Here, since the temperature of the lid of the manhole was around 25°C to 60°C in the summer in the heart of Tokyo, around 5°C to 25°C in the winter, the first heat storage materials 5 and the second heat storage material 5X were used as the heat storage material.

Further, since the nested structure was employed as described above, it was possible to deal with it through one thermoelectric conversion module 6.

As a result, in the thermoelectric conversion module 6 of the present fourth example, the output voltage was a maximum of 0.4 V in the summer and a maximum of 0.2 V in the winter, and it was possible to secure the temperature difference between the temperature (melting point) of the heat storage materials 5 and 5X and the temperature of the lid of the manhole and obtain the sufficient power generation amount.

### [Second Embodiment]

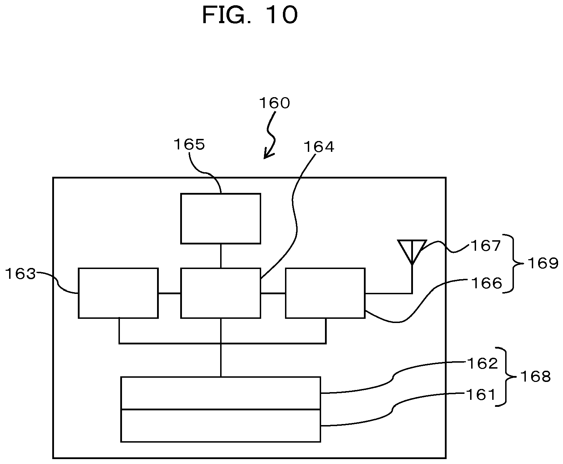

Next, a sensor module and an information processing system according to a second embodiment will be described with reference to Figs. 10 to 16.

A sensor module according to the present embodiment is an integrated module, and an integrated module 160 includes a power generation module 161, an electric storage module 162, a sensor 163, a controller 164, a memory 165, a communication circuit 166, and an antenna 167 as illustrated in Fig. 10

For example, the thermoelectric conversion module 6 of the first embodiment is applied as the power generation module 161. In other words, the power generation module 161 includes the thermoelectric conversion device 1, the container 2, the fin 3, the heat dissipation member 4, and the heat storage material 5. Thus, the present sensor module includes at least the sensor 163 and the thermoelectric conversion module 6 of the first embodiment which is electrically connected to the sensor 163.

The electric storage module 162 is connected to the power generation module 161 and stores electric power generated through the power generation module 161. A module has the function of storing electric power is preferably used as the electric storage module 162. For example, an all solid-state secondary battery is preferably used as the electric storage module 162 since a space is saved, and safety is high.

The power generation module 161 and the electric storage module 162 constitute a power supply unit 168. Electric power is supplied to the sensor 163, the controller 164, and the communication circuit 166 from at least one of the power generation module 161 and the electric storage module 162 constituting the power supply unit 168. In a case where stable electric power is able to be supplied through the power generation module 161, the electric storage module 162 may be omitted.

For example, a sensor that detect a temperature, humidity, pressure, light, a sound, an electromagnetic wave, acceleration, vibration, gas, fine particles, or the like is applicable as the sensor 163. Further, for example, a distance measuring sensor that emits infrared light to an object, receives light reflected from the object, and measures a distance to the object, a weight sensor that measures a weight of an object, a water level sensor that detects data such as a water level, or the like is applicable as the sensor 163.

For example, the controller 164 transmits various kinds of data detected by the sensor 163 to a server 175 via the communication circuit 166 and the antenna 167. For example, the controller 164 may transmit secondary data based on various kinds of data detected by the sensor 163 and other data to the server 175. Further, for example, the controller 164 may calculate secondary data by performing a predetermined calculation using various kinds of data detected by the sensor 163 and transmit the secondary data to the server 175.

The memory 165 stores various kinds of data detected by the sensor 163 or the calculated secondary data in accordance with a command of the controller 164. The stored information is read out in accordance with a command of the controller 164.

The communication circuit 166 and the antenna 167 constitute a communication unit 169. The communication unit 169 performs transmission and reception of data between the controller 164 and the server 175 (not illustrated) . In the example illustrated in Fig. 10, wireless communication using the antenna 167 is employed, but wired communication may be employed instead of wireless communication.

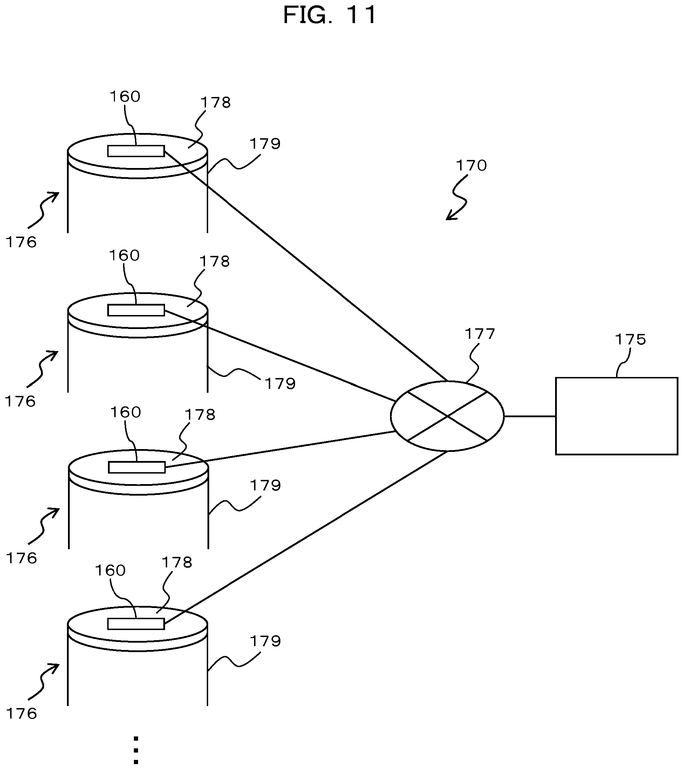

For example, the integrated module 160 is applied to an information processing system 170 according to the present embodiment as illustrated in Fig. 11.

The information processing system 170 includes a plurality of integrated modules 160 and the server 175. In other words, the present information processing system 170 includes the integrated module (sensor module) 160 and the server (computer) 175 that processes the data obtained by the integrated module 160. Here, the information processing system 170 is a system that processes information obtained from a manhole 176. Therefore, a plurality of integrated modules 160 are disposed in the manholes 176. The plurality of integrated modules 160 disposed in the plurality of manhole 176 are connected to the server 175 via a network 177.

For example, each time a vehicle equipped with the server 175 travels and approaches the integrated module 160 installed in each manhole 176, data may be transmitted from the integrated module 160 to the server 175 through near field communication. Further, the integrated module 160 may be installed at any place as long as it is a structure of the manhole 176.

The integrated module 160 is fixed to a lid 178, a concrete pipe 179 and so forth which is a structure body of the manhole 176 in accordance with a detection target of the sensor 163 or a type of sensor 163. The thermoelectric conversion device installed in the integrated module 160 is thermally connected with the structure body of the manhole 176 and generates electric power in accordance with the temperature difference between the structure body of manhole 176 and the outside temperature or the temperature in the manhole 176.

Specific application examples of the information processing system 170 according to the present embodiment will be described below.

### [First Application Example]

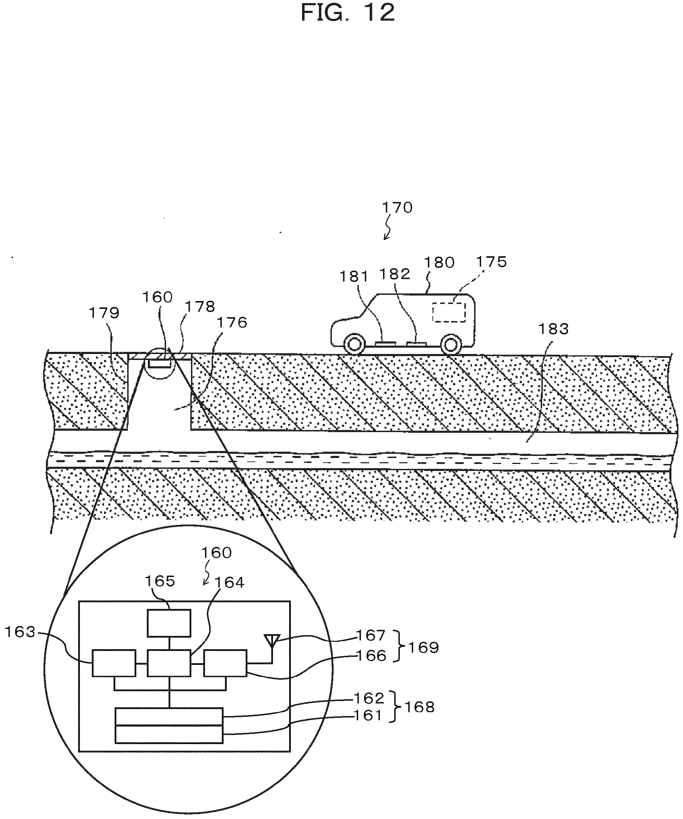

In a first application example, the information processing system 170 is used to detect deterioration of the structure body of the manhole 176 (the lid 178 or the concrete pipe 179) as illustrated in Fig. 12.

The sensor 163 detects a temperature and humidity in the manhole 176, vibration (acceleration) acting on the structure body of the manhole 176, and the like, and the data detected by the sensor 163 is accumulated in the memory 165.

When a measuring vehicle 180 traveling on a road passes over the manhole 176, the controller 164 transmits the data stored in the memory 165 via the communication circuit 166 and the antenna 167. The server 175 disposed in the measuring vehicle 180 collects data.

The server 175 combines position information of the vehicle 180 obtained by a global positioning system (GPS) and the collected data, and causes the collected data to be displayed on a map displayed on an in-vehicle monitor. It is possible to estimate a degree of deterioration of the concrete pipe 179 in each manhole 176 on the basis of information indicating the temperature, the humidity, the vibration, and the like.

In addition to a receiving device 181, a camera 182 that acquires an image of the lid 178 of the manhole 176 may be attached to the bottom of the measuring vehicle 180, and thus it is possible to determine the deterioration of the lid 178 (iron portion) of the manhole 176 through image recognition. On the basis of the result, an exchange time for exchanging the lid 178 of the manhole 176 may be sold to local governments as information. Here, for example, a garbage collecting vehicle operated by a local government rather than a special measuring vehicle may be used as the vehicle that collects data.

In a case where the receiving device 181 and the camera 182 are installed at the bottom of the garbage collecting vehicle, it is possible to collect data regularly with no collection expense.

Further, the sensor 163 may detect a concentration of gas generated in the manhole 176. The gas generated in the manhole 176 is, for example, hydrogen sulfide gas. The hydrogen sulfide gas generated in a sewer 183 is known to abruptly degrade the structure body of the manhole 176. The generation of the hydrogen sulfide gas is a complaint factor from neighborhood residents. In a case where the hydrogen sulfide gas sensor is used as the sensor 163, it is possible to rapidly deal with complaints of the residents while improving the degradation prediction accuracy for the structure body of the manhole 176.

In the first application example, the sensor 163 may be any sensor as long as the sensor is able to detect at least one of the temperature, the humidity, and the vibration in manhole 176 and the concentration of the gas generated in the manhole 176.

Further, the humidity in the manhole 176 is always high, and the manhole 176 may be full of the water of the sewer 183 (or drinking water supply). Further, the inside of the manhole 176 has substantially a constant temperature, but it is known that, for example, in the lid 178, a temperature is high in the summer and low in the winter, and a hydrogen sulfide gas or the like in which various metals are dissolved is generated. In such a harsh environment, it is important to protect electronic parts such as the sensor 163 and the thermoelectric conversion device and maintain long-term reliability. In this case, in a case where the integrated module 160 is configured such that the electronic parts such as the sensor 163 and the thermoelectric conversion device are sealed with resin, it is possible to maintain the long-term reliability.

### [Second Application Example]

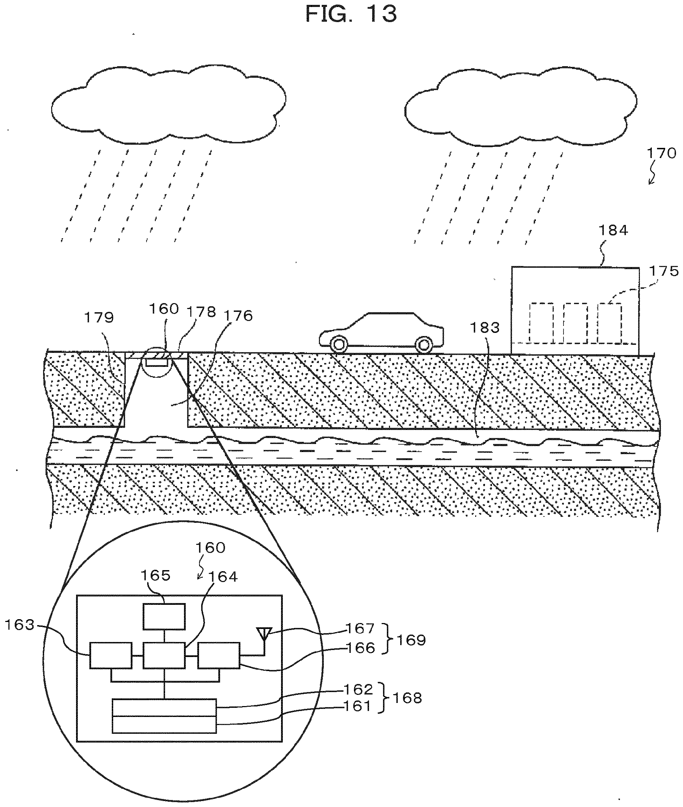

In a second application example, the information processing system 170 is used to predict a flow rate of the sewer 183 connected to the manhole 176, as illustrated in Fig. 13.

For example, a water level gauge or a flow meter is used as the sensor 163. When the sensor 163 which is the water level gauge or the flow meter is installed in manhole 176, it is possible to detect the water level or the flow rate of the sewer 183 finely. In Fig. 13, the sensor 163 is incorporated into the integrated module 160, but for example, a sensor control unit that controls an operation of an external sensor may be disposed instead of the sensor 163. In this case, it is desirable that the sensor control unit control a sensor (not illustrated) such as the water level gauge or the flow meter arranged in the sewer 183 and acquire information detected by that sensor. Further, the information detected by the sensor may be wirelessly transmitted to the sensor control unit.

Specifically, the water level or the flow rate of the sewer 183 are detected by the sensor 163 once a day or once an hour, and data detected by the sensor 163 is collected in the server 175 of a data center 184 via a high-speed communication line. The data of the water level or the flow rate of the sewer 183 detected by the sensor 163 may be transmitted simultaneously at the same time as measurement or may be accumulated for one day or one week and then transmitted in order to reduce power consumption. Similarly to the first application example, the measuring vehicle may collect the data.

Typically, since rainwater flows into the sewer 183, prediction of the water level or the flow rate of the sewer 183 is strongly linked with rainfall data. For this reason, when the data of the water level or the flow rate of the sewer 183 collected by the sensor 163 and the rainfall data given from a meteorological agency are combined and analyzed, for example, it is possible to provide flood prediction for rivers into which the water of the sewer 183 flows, a warning, or warning information.

It is also possible to establish a relation between a weather phenomenon and the water level or the flow rate of sewer 183 on the basis of a result of analyzing the data of the water level or the flow rate data of the sewer 183 and the rainfall data given from the meteorological agency. Further, the water level or the flow rate of the sewer 183 may be predicted at various places on the basis of the rainfall data given from the meteorological agency, and provision and distribution of the prediction data may be charged. Since the water level or the flow rate of the sewer 183 changes year by year in accordance with housing construction, living conditions, or land development situations, the present information processing system 170 capable of continuously updating the data is useful.

Further, in the second application example, the information processing system 170 is also able to be used for measuring the water level or the flow rate of the sewer 183 in a case where local concentrated heavy rain or the like occurs. In the case of the local concentrated heavy rain in cities, it is desirable to measure the water level or the flow rate of the sewer 183 and transmit information at intervals of minutes in order to protect safety of workers working in the sewer 183 and prevent flooding of the sewer 183. In this case, it is desirable to collect data only from the integrated modules 160 disposed in a small number of manhole 176 having a relatively low elevation.

It is desirable to sufficiently store electric power in the electric storage module 162 of the integrated module 160 that measures the water level in advance. The controller 164 sequentially transmits data to the server 175 via the communication circuit 166 and the high-speed communication line. The server 175 is able to issue a warning to smartphones or tablets of workers or residents near the flood on the basis of the received data. Alternatively, a measuring vehicle may be parked on a specific manhole 176 so that data is collected by a server disposed in the vehicle through near field communication.

### [Third Application Example]

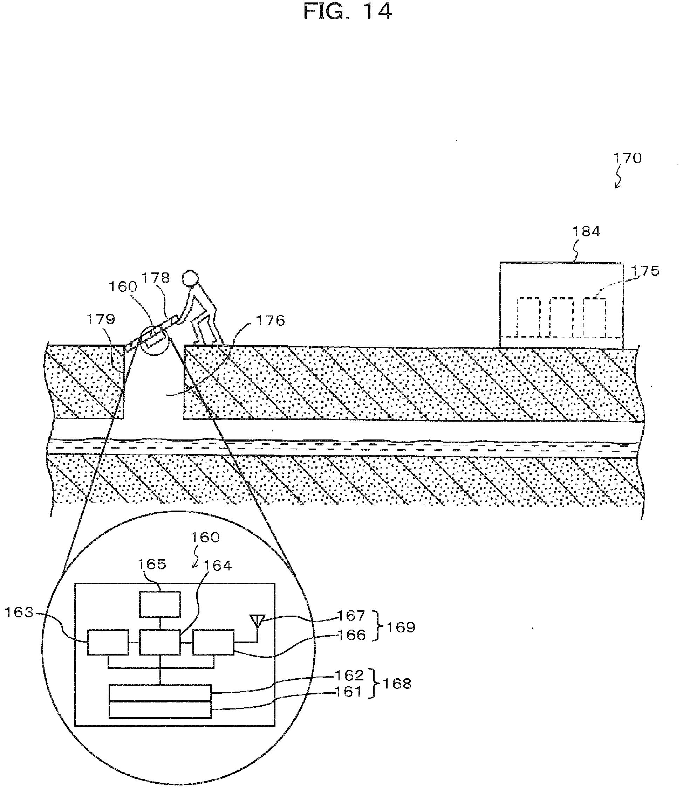

In a third application example, the information processing system 170 is used for security and work history for the manhole 176 as illustrated in Fig. 14.

The sensor 163 detects opening and closing of the lid 178 of the manhole 176. For example, an acceleration sensor or an open/close switch is used as the sensor 163. In order to detect the opening and closing of the lid 178 of the manhole 176, it is desirable for the sensor 163 to detect at least one of acceleration generated in the lid 178 of the manhole 176 and an open/closed state of the lid 178 of the manhole 176. The data (signal) output from the sensor 163 in accordance with the opening/closing of the lid 178 of the manhole 176 is received by the server 175.

According to the information processing system 170, it is possible to check security countermeasures (for example, countermeasures for terrorist explosions or the like) for the sewer 183 or the like or a work history for a work of cleaning the sewer 183.

### [Fourth Application Example]

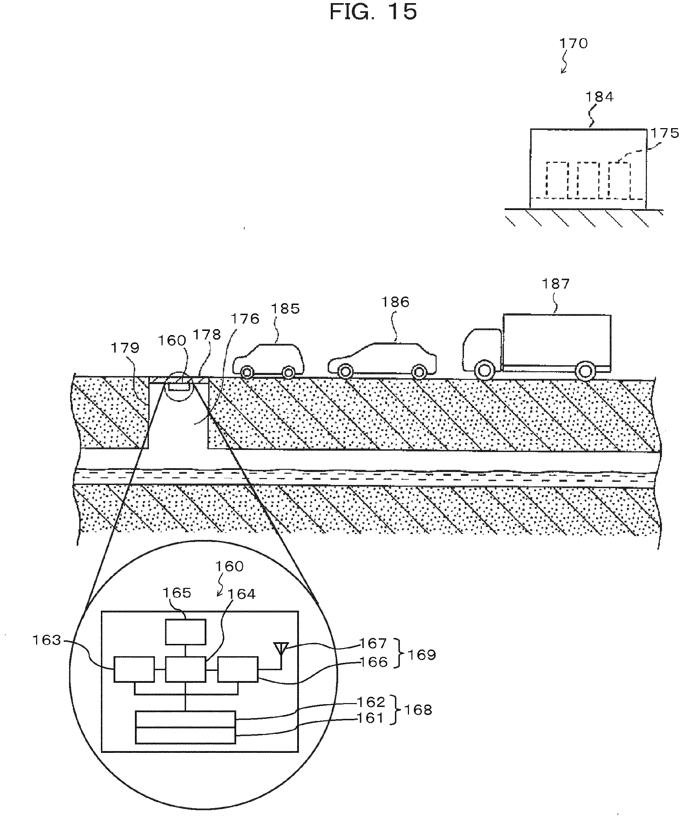

In a fourth application example, the information processing system 170 is used for acquiring road traffic information as illustrated in Fig. 15.

The sensor 163 detects vehicles 185, 186, and 187 passing over the manhole 176. For example, an acceleration sensor, a magnetic sensor, a microphone, or the like is used as the sensor 163. Signals corresponding to the number of vehicles passing over manhole 176 are obtained from the sensor 163. Data (signals) output from the sensor 163 are received by the server 175.

According to the information processing system 170, it is possible to obtain congestion information even on narrow roads, alleys, or the like which are not measured through current road traffic information communication systems. Accordingly, it is possible to provide detailed congestion information.

Further, types of the vehicles 185, 186, and 187 passing over the manhole 176 (for example, a compact car, a regular car, a truck, or the like) may be detected on the basis of strength of a detection value of the sensor 163. In this case, it is desirable to store a data set in which the detection value of the sensor 163 is associated with a type of vehicle in the memory 165 in advance. Then, it is desirable for the controller 164 to determine a type of vehicle on the basis of the detection value of the sensor 163 and the data set and transmit information indicating the type of vehicle to the server 175. Accordingly, it is possible to detect the type of vehicle passing over the manhole 176.

Furthermore, individual identification information of the vehicles 185, 186, and 187 passing over the manhole 176 may be detected by the sensor 163. For example, in a case where a magnetic sensor is used as the sensor 163, characteristics of the vehicle may be obtained in accordance with a response from the magnetic sensor. In other words, for example, it is possible to identify each vehicle when a medium that emits magnetism specific to each vehicle is mounted in a vehicle. When a difference in the flow of vehicles in urban areas according to a vehicle type is analyzed, it may be used for city road control or city evaluation such as planning of guiding specific vehicles to specific roads.

In the fourth application example, it is desirable for the sensor 163 to detect at least one of the number of vehicles passing over the manhole 176, types of the vehicles, and individual identification information of the vehicles.

### [Fifth Application Example]

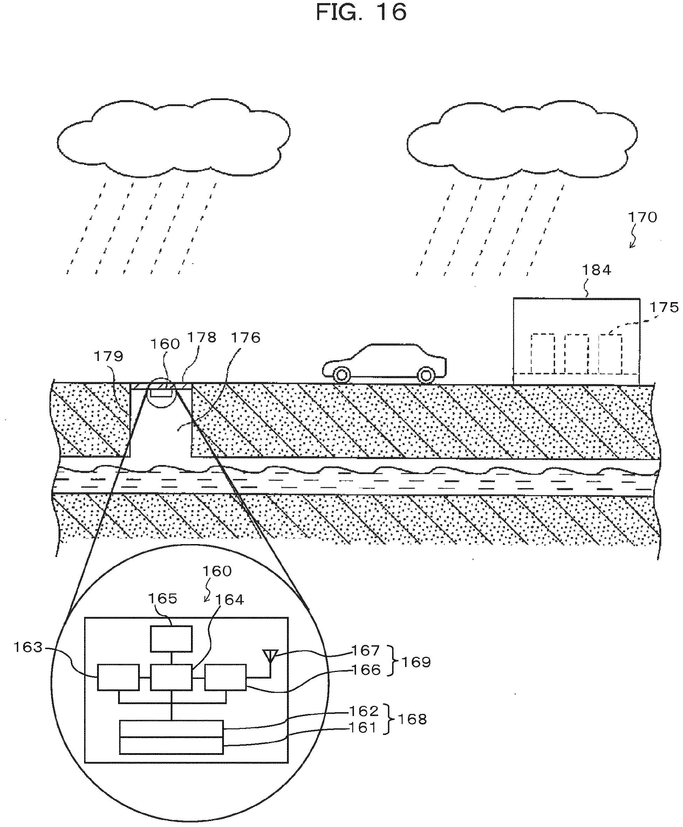

In a fifth application example, the information processing system 170 is used for measuring a rainfall amount as illustrated in Fig. 16.

For example, an X band radar for weather forecast is used as the sensor 163. For example, a radio wave of the X band radar does not arrive at a heavy rainy area during heavy rain and is unable to cross large objects such as mountains. Further, in current radars, it is often difficult to find and track heavy rainy areas which abruptly occurs or are suddenly developed. A high temporal spatial resolution is needed for high accuracy prediction.

Typically, a resolution of the X band radar is 250 m, but when the sensor 163 is installed in the manhole 176 with an average interval of about 30 m, it is possible to perform finer weather observation, and it is helpful for measurement and prediction of local concentrated heavy rain or the like. Data (signal) output from the sensor 163 is received by the server 175.

In the first to fifth application examples, the dedicated server 175 is used, but a general-purpose computer may be used as the server 175. Further, a program causing a general-purpose computer functioning as the server 175 to perform operations performed by the controller 164 or the server 175 may be installed and executed. In this case, the program may be supplied through a recording medium or may be downloaded from a network.

### REFERENCE SIGNS LIST

- 1: thermoelectric conversion device
- 2: container (first container)
- 2X: second container
- 3: fin
- 3A: base portion
- 3X: heat sink
- 4: heat dissipation member (first heat dissipation member)
- 4X: second heat dissipation member
- 5: heat storage material (first heat storage material)
- 5X: second heat storage material
- 6: thermoelectric conversion module
- 7: heat transfer member (second heat transfer member)
- 7X: first heat transfer member
- 8: heat source
- 9: electronic part
- 10: board
- 10A: opening portion
- 11: external connection terminal
- 12: sealing material
- 13: connector
- 160: integrated module
- 161: power generation module
- 162: electric storage module
- 163: sensor
- 164: controller
- 165: memory
- 166: communication circuit (communication unit)
- 167: antenna
- 168: power supply unit
- 169: communication unit
- 170: information processing system
- 175: server (computer)
- 176: manhole
- 177: network
- 178: lid
- 179: concrete pipe
- 180: vehicle
- 181: receiving device
- 182: camera
- 183: sewer
- 184: data center
- 185, 186, 187: vehicle

## Claims

1. A thermoelectric conversion module, comprising:
a thermoelectric conversion device;
a first container;
a fin that is thermally connected to one side of the thermoelectric conversion device, has a higher thermal conductivity than the first container, and extends in a direction away from the thermoelectric conversion device in the first container;
**characterised by** a first heat dissipation member that is thermally connected to the one side of the thermoelectric conversion device, has a higher thermal conductivity than the fin, and extends up to a side far from the thermoelectric conversion device of the fin in the first container; and
a first heat storage material that is disposed in the first container and thermally connected to the fin and the first heat dissipation member.

2. The thermoelectric conversion module according to claim 1, further comprising,
a heat transfer member that is disposed in the first container and has a higher thermal conductivity than the first container,
wherein the thermoelectric conversion device is disposed in the first container, and an opposite side to the one side is thermally connected to the heat transfer member.

3. The thermoelectric conversion module according to claim 1, further comprising,
a heat transfer member that is disposed outside the first container,
wherein the thermoelectric conversion device is disposed outside the first container, and an opposite side to the one side is thermally connected to the heat transfer member.

4. The thermoelectric conversion module according to claim 1, further comprising:
a first heat transfer member that is disposed in the first container and has a higher thermal conductivity than the first container; and
a second heat transfer member that is disposed outside the first container,
wherein the thermoelectric conversion device is disposed outside the first container, the one side is thermally connected to the fin and the first heat dissipation member via the first heat transfer member, and an opposite side to the one side is thermally connected to the second heat transfer member.

5. The thermoelectric conversion module according to any one of claims 1 to 3, further comprising,
a board that includes an opening portion, an electronic part being mounted on the board,
wherein the thermoelectric conversion device is disposed in the opening portion of the board and electrically connected to the board.

6. The thermoelectric conversion module according to claim 4, further comprising,
a board that includes an opening portion, an electronic part being mounted on the board,
wherein the first heat transfer member is disposed in the opening portion of the board, and
the thermoelectric conversion device is electrically connected to the board.

7. The thermoelectric conversion module according to any one of claims 1 to 6,
wherein the first heat dissipation member is disposed to surround the fin.

8. The thermoelectric conversion module according to any one of claims 1 to 7, further comprising,
a second heat dissipation member that is thermally connected to the one side of the thermoelectric conversion device, has a thermal conductivity which is higher than the fin and different from the first heat dissipation member, and extends up to a side far from the thermoelectric conversion device of the fin in the first container.

9. The thermoelectric conversion module according to claim 8, further comprising:
a second container that is disposed in the first container, the fin, the first heat dissipation member, and the first heat storage material being disposed in the second container; and
a second heat storage material that is disposed in the first container and outside the second container, thermally connected to at least the second heat dissipation member, and has a melting point different from the first heat storage material.

10. A sensor module, comprising:
a sensor; and
the thermoelectric conversion module according to any one of claims 1 to 9, the thermoelectric conversion module being electrically connected to the sensor.

11. An information processing system, comprising:
the sensor module according to claim 10; and
a computer that processes data obtained through the sensor module.

## Patentansprüche

1. Thermoelektrisches Umwandlungsmodul, umfassend:
eine thermoelektrische Umwandlungsvorrichtung;
einen ersten Behälter;
eine Rippe, die mit einer Seite der thermoelektrischen Umwandlungsvorrichtung thermisch verbunden ist, eine höhere Wärmeleitfähigkeit als der erste Behälter aufweist und sich in einer Richtung, die sich von der thermoelektrischen Umwandlungsvorrichtung entfernt, in dem ersten Behälter erstreckt;
**gekennzeichnet durch**
ein erstes Wärmeableitelement, das mit der einen Seite der thermoelektrischen Umwandlungsvorrichtung thermisch verbunden ist, eine höhere Wärmeleitfähigkeit als die Rippe aufweist und sich bis zu einer Seite hin, die von der thermoelektrischen Umwandlungsvorrichtung der Rippe entfernt ist, in dem ersten Behälter erstreckt; und
ein erstes Wärmespeichermaterial, das in dem ersten Behälter angeordnet ist und mit der Rippe und dem ersten Wärmeableitelement thermisch verbunden ist.

2. Thermoelektrisches Umwandlungsmodul nach Anspruch 1, ferner umfassend:
ein Wärmeübertragungselement, das in dem ersten Behälter angeordnet ist und eine höhere Wärmeleitfähigkeit als der erste Behälter aufweist,
wobei die thermoelektrische Umwandlungsvorrichtung in dem ersten Behälter angeordnet ist und eine Seite, die der einen Seite gegenüberliegt, mit dem Wärmeübertragungselement thermisch verbunden ist.

3. Thermoelektrisches Umwandlungsmodul nach Anspruch 1, ferner umfassend:
ein Wärmeübertragungselement, das außerhalb des ersten Behälters angeordnet ist, wobei die thermoelektrische Umwandlungsvorrichtung außerhalb des ersten Behälters angeordnet ist, und eine Seite, die der einen Seite gegenüberliegt, mit dem Wärmeübertragungselement thermisch verbunden ist.

4. Thermoelektrisches Umwandlungsmodul nach Anspruch 1, ferner umfassend:
ein erstes Wärmeübertragungselement, das in dem ersten Behälter angeordnet ist und eine höhere Wärmeleitfähigkeit als der erste Behälter aufweist; und
ein zweites Wärmeübertragungselement, das außerhalb des ersten Behälters angeordnet ist, wobei die thermoelektrische Umwandlungsvorrichtung außerhalb des ersten Behälters angeordnet ist, die eine Seite mit der Rippe und dem ersten Wärmeableitelement über das erste Wärmeübertragungselement thermisch verbunden ist, und eine Seite, die der einen Seite gegenüberliegt mit dem zweiten Wärmeübertragungselement thermisch verbunden ist.

5. Thermoelektrisches Umwandlungsmodul nach einem der Ansprüche 1 bis 3, ferner umfassend eine Platine, die einen Öffnungsabschnitt umfasst, wobei ein elektronisches Bauteil auf der Platine montiert ist,
wobei die thermoelektrische Umwandlungsvorrichtung in dem Öffnungsabschnitt der Platine angeordnet ist und mit der Platine elektrisch verbunden ist.

6. Thermoelektrisches Umwandlungsmodul nach Anspruch 4, ferner umfassend:
eine Platine, die einen Öffnungsabschnitt umfasst, wobei ein elektronisches Bauteil auf der Platine montiert ist,
wobei das erste Wärmeübertragungselement in dem Öffnungsabschnitt der Platine angeordnet ist, und
die thermoelektrische Umwandlungsvorrichtung mit der Platine elektrisch verbunden ist.

7. Thermoelektrisches Umwandlungsmodul nach einem der Ansprüche 1 bis 6,
wobei das erste Wärmeableitelement angeordnet ist, um die Rippe zu umgeben.

8. Thermoelektrisches Umwandlungsmodul nach einem der Ansprüche 1 bis 7, ferner umfassend:
ein zweites Wärmeableitelement, das mit der einen Seite der thermoelektrischen Umwandlungsvorrichtung thermisch verbunden ist, eine Wärmeleitfähigkeit aufweist, die höher als die Rippe ist, und anders als das erste Wärmeableitelement ist, und sich bis zu einer Seite hin, die von der thermoelektrischen Umwandlungsvorrichtung der Rippe entfernt ist, in dem ersten Behälter erstreckt.

9. Thermoelektrisches Umwandlungsmodul nach Anspruch 8, ferner umfassend:
einen zweiten Behälter, der in dem ersten Behälter angeordnet ist, wobei die Rippe, das erste Wärmeableitelement und das erste Wärmespeichermaterial in dem zweiten Behälter angeordnet sind; und
ein zweites Wärmespeichermaterial, das in dem ersten Behälter und außerhalb des zweiten Behälters angeordnet ist, mit mindestens dem zweiten Wärmeableitelement thermisch verbunden ist und einen anderen Schmelzpunkt als das erste Wärmespeichermaterial aufweist.

10. Sensormodul, umfassend:
einen Sensor; und
das thermoelektrische Umwandlungsmodul nach einem der Ansprüche 1 bis 9, wobei das thermoelektrische Umwandlungsmodul mit dem Sensor elektrisch verbunden ist.

11. Informationsverarbeitungssystem, umfassend:
das Sensormodul nach Anspruch 10; und
einen Computer, der Daten verarbeitet, die durch das Sensormodul erzielt werden.

## Revendications

1. Module de conversion thermoélectrique, comprenant :
un dispositif de conversion thermoélectrique ;
un premier récipient ;
une ailette qui est thermiquement reliée à un premier côté du dispositif de conversion thermoélectrique, présente une conductivité thermique supérieure à celle du premier récipient, et s'étend dans une direction opposée au dispositif de conversion thermoélectrique dans le premier récipient ;
**caractérisé par**
un premier élément de dissipation de chaleur qui est connecté thermiquement au premier côté du dispositif de conversion thermoélectrique, présente une conductivité thermique supérieure à celle de l'ailette, et s'étend jusqu'à un côté éloigné du dispositif de conversion thermoélectrique de l'ailette dans le premier récipient ; et
un premier matériau de stockage de chaleur qui est disposé dans le premier récipient et relié thermiquement à l'ailette et au premier élément de dissipation de chaleur.

2. Module de conversion thermoélectrique selon la revendication 1, comprenant en outre,
un élément de transfert thermique qui est disposé dans le premier récipient et a une conductivité thermique supérieure à celle du premier récipient,
dans lequel le dispositif de conversion thermoélectrique est disposé dans le premier récipient, et un côté opposé au premier côté est relié thermiquement à l'élément de transfert de chaleur.

3. Module de conversion thermoélectrique selon la revendication 1, comprenant en outre,
un élément de transfert de chaleur qui est disposé à l'extérieur du premier récipient,
dans lequel le dispositif de conversion thermoélectrique est disposé à l'extérieur du premier récipient, et un côté opposé au premier côté est thermiquement relié à l'élément de transfert de chaleur.

4. Module de conversion thermoélectrique selon la revendication 1, comprenant en outre
un premier élément de transfert de chaleur qui est disposé dans le premier récipient et présente une conductivité thermique supérieure à celle du premier récipient ; et
un second élément de transfert de chaleur qui est disposé à l'extérieur du premier récipient,
dans lequel le dispositif de conversion thermoélectrique est disposé à l'extérieur du premier récipient, le premier côté est relié thermiquement à l'ailette et au premier élément de dissipation de chaleur via le premier élément de transfert de chaleur, et un côté opposé au premier côté est relié thermiquement au second élément de transfert de chaleur.

5. Module de conversion thermoélectrique selon l'une quelconque des revendications 1 à 3, comprenant en outre,
une carte comportant une partie d'ouverture, une partie électronique étant montée sur la carte,
dans lequel le dispositif de conversion thermoélectrique est disposé dans la partie d'ouverture de la carte et est relié électriquement à la carte.

6. Module de conversion thermoélectrique selon la revendication 4, comprenant en outre,
une carte comportant une partie d'ouverture, une partie électronique étant montée sur la carte,
dans lequel le premier élément de transfert de chaleur est disposé dans la partie d'ouverture de la carte, et
le dispositif de conversion thermoélectrique est connecté électriquement à la carte.

7. Module de conversion thermoélectrique selon l'une quelconque des revendications 1 à 6,
dans lequel le premier élément de dissipation de chaleur est disposé pour entourer l'ailette.

8. Module de conversion thermoélectrique selon l'une quelconque des revendications 1 à 7, comprenant en outre,
un deuxième élément de dissipation de chaleur qui est relié thermiquement au premier côté du dispositif de conversion thermoélectrique, a une conductivité thermique qui est supérieure à celle de l'ailette et différente de celle du premier élément de dissipation de chaleur, et s'étend jusqu'à un côté éloigné du dispositif de conversion thermoélectrique de l'ailette dans le premier récipient.

9. Module de conversion thermoélectrique selon la revendication 8, comprenant en outre :
un second récipient qui est disposé dans le premier récipient, l'ailette, le premier élément de dissipation de chaleur, et le premier matériau de stockage de chaleur étant disposés dans le second récipient ; et
un second matériau de stockage de chaleur qui est disposé dans le premier récipient et à l'extérieur du second récipient, relié thermiquement au moins au second élément de dissipation de chaleur, et a un point de fusion différent de celui du premier matériau de stockage de chaleur.

10. Module de capteur, comprenant
un capteur ; et
le module de conversion thermoélectrique selon l'une quelconque des revendications 1 à 9, le module de conversion thermoélectrique étant relié électriquement au capteur.

11. Système de traitement d'informations, comprenant :
le module de capteur selon la revendication 10 ; et
un ordinateur qui traite des données obtenues via le module de capteur.
